# EUROPÄISCHE PATENTSCHRIFT

(11) **EP 0 768 020 B1**
(45) Veröffentlichungstag und Bekanntmachung des Hinweises auf die Patenterteilung: **02.09.1998**
(21) Anmeldenummer: 95922418.9
(22) Anmeldetag: 27.06.1995
(51) Int. Cl.: H05K 13/04

(54) **VORRICHTUNG ZUR HANDHABUNG VON TEILEN MIT MINDESTENS EINER SAUGPIPETTE**
DEVICE FOR HANDLING PARTS COMPRISING AT LEAST ONE SUCTION TUBE
DISPOSITIF DE MANUTENTION DE PIECES COMPRENANT AU MOINS UN TUBE D'ASPIRATION

(30) Priorität: 30.06.1994 DE 4423008
(43) Veröffentlichungstag der Anmeldung: 16.04.1997
(73) Patentinhaber: SIEMENS AKTIENGESELLSCHAFT, 80333 München (DE)
(72) Erfinder: KRUG, Klaus, D-81545 München (DE); WACKER, Josef, D-82335 Berg (DE)
(86) Internationale Anmeldenummer: DE9500832
(87) Internationale Veröffentlichungsnummer: WO9601036

(56) Entgegenhaltungen:
- EP-A- 0 008 379
- EP-A- 0 065 604
- EP-A- 0 534 701
- US-A- 4 135 630

## Beschreibung

Aus der US-A-4 135 630 ist eine Vorrichtung zum Bestücken von Leiterplatten mit Bauelementen bekannt, deren in X-, Y-Richtung verfahrbarer Bestückkopf mit einer nach unten ragenden Saugpipette ausgerüstet ist. Mit dieser Saupipette werden die einzelnen Bauelemente aus einer Zuführeinrichtung entnommen, durch Verfahren des Bestückkopfes in X-, Y-Richtung zur Leiterplatte hin verfahren und dann in einer vorgegebenen Bestückposition auf der Leiterplatte abgelgt. Die Saugpipette ist dabei an eine variable Druckquelle angeschlossen, mit welcher zum Aufnehmen und Halten der Bauelemente ein Unterdruck und zum Abgeben der Bauelemente ein positiver Druck erzeugt wird.

Aus der US-A-4 458 412 ist eine andere Vorrichtung zum Bestücken von Leiterplatten mit Bauelementen bekannt, bei welcher ein drehbar angeordneter Revolverkopf mit mehreren, in gleichmäßiger Umfangsteilung angeordneten Saupipetten ausgerüstet ist. Mit den einzelnen Saugpipetten werden die Bauelemente aus einer Zuführeinrichtung entnommen, beim Weiterdrehen des Revolverkopfes nacheinander einer Teststation, einer Abwurfstation und einer Orientierungsstation zugeführt und dann schließlich in einer vorgegebenen Bestückposition auf der zugeordneten Leiterplatte abgelegt. Die jeweilige Bestückposition wird dabei durch ein entsprechendes Verfahren der Leiterplatte in X-, Y-Richtung eingenommen. Die Saugpipetten sind zum Aufnehmen und Halten der Bauelemente mit einer sogenannten Vakuumquelle verbunden, während zum Abgeben der Bauelemente in der Bestückposition und gegebenenfalls in der Abwurfposition Blasluft in die Saugpipetten eingeleitet wird.

Der im Anspruch 1 angegebenen Erfindung liegt das Problem zugrunde, bei einer Vorrichtung zum Bestücken von Leiterplatten mit Bauelementen den in einer Saugpipette zum Aufnehmen und Halten der Bauelemente erforderlichen Unterdruck beim bzw. kurz nach dem Aufsetzen eines Bauelements auf einer Leiterplatte, möglichst schnell und definiert abzubauen. Insbesondere soll verhindert werden, daß die auf der Leiterplatte zu positionierenden Bauelemente beim Zurückfahren der Saugpipette wieder mitgerissen werden, und daß benachbarte Bauelemente in ihrer Lage verschoben oder weggeblasen werden.

Neben der Bestückung von Leiterplatten mit Bauelementen kann die im Anspruch 1 angegebene Druckumsteuerung von Unterdruck auf Blasluft auch allgemein in Montageeinrichtungen eingesetzt werden, bei welchen die Handhabung von kleinen oder leichten Teilen mit Hilfe von Saugpipetten vorgenommen wird.

Die mit der Erfindung erzielten Vorteile bestehen insbesondere darin, daß das unter Unterdruck stehende Volumen zwischen Pumpe und Saugpipette einschließlich des Leitungsvolumens aus dem Druckbehälter bei Betätigung des Ventils schnell mit relaitv hohem Druck aufgefüllt werden kann. Die Abgabe des Behälterinhalts in den Unterdruckbereich bewirkt einen sehr schnellen und definierten Druckanstieg in der Saugpipette und damit eine sichere und lagerichtige Positionierung der Bauelemente auf der Leiterplatte.

Vorteilhafte Ausgestaltungen der Erfindung sind in den Unteransprüchen angegeben.

Die Ausgestaltung nach Anspruch 2 ermöglicht eine besonders einfache Erzeugung des Unterdrucks mit Hilfe einer Strahlpumpe, wobei die zum Betrieb der Strahlpumpe erforderliche Druckluftquelle gleichzeitig auch zum Füllen des Druckbehälters herangezogen wird. Durch eine entsprechende Bemessung des zwischen Druckluftquelle und Druckluftbehälter angeordneten Drosselorgans kann auch bei laufender Strahlpumpe ein konstanter Druck gehalten werden.

Ist der Querschnitt des Drosselorgans gemäß Anspruch 3 einstellbar, so kann über die Drosselwirkung der in der Saugpipette beim Abgeben eines Bauelements herrschende Druck beeinflußt und an die jeweiligen Erfordernisse optimal angepaßt werden.

Ist das Volumen des Druckbehälters gemäß Anspruch 4 einstellbar, so können über eine entsprechende Wahl dieses Volumens die Steilheit der Blasdruck-Kennlinie und die maximale Höhe des Blasdrucks an die jeweiligen Erfordernisse optimal angepaßt werden.

Ausführungsbeispiele der Erfindung sind in der Zeichnung dargestellt und werden im folgenden näher beschrieben.

Es zeigen
- Figur 1: das Prinzip einer schnellen Umsteuerung des in einer Saugpipette herrschenden Druckes von Unterdruck auf Blasluft,
- Figur 2: eine Variante des in Figur 1 dargestellten Prinzips mit einem einstellbaren Drosselorgan zwischen Druckluftquelle und Druckbehälter und mit einem einstellbaren Volumen des Druckbehälters,
- Figur 3: den Einfluß des Volumens des Druckbehälters auf die Blasdruck-Kennlinie und
- Fiur 4: den Einfluß des Querschnitts des Drosselorgans auf die Blasdruck-Kennlinie.

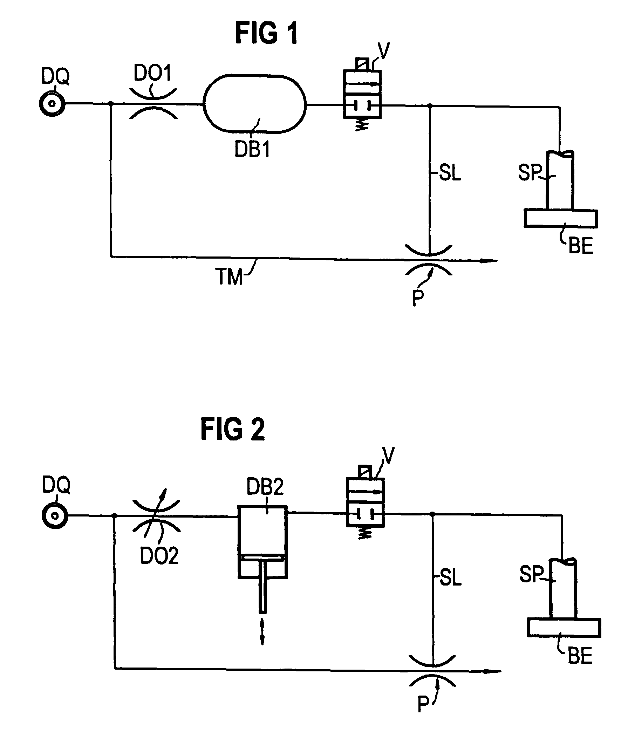

Figur 1 zeigt in stark vereinfachter schematischer Darstellung die Umsteuerung des in einer Saugpipette SP herrschenden Druckes von Unterdruck auf Blasluft. Der zum Aufnehmen und Halten eines Bauelementes BE erforderliche Unterdruck wird mit Hilfe einer Pumpe P erzeugt, deren Saugleitung SL mit der Saugpipette SP verbunden ist. Bei der Pumpe P handelt es sich um eine Strahlpumpe, deren Treibmittel TM einer Druckluftquelle DQ entnommen wird.

Die zum Betrieb der Pumpe P erforderliche Druckluftquelle DQ, bei welcher es sich um einen normalen Anschluß eines Druckluftnetzes handeln kann, füllt andererseits über ein Drosselorgan DO1 einen Druckbehälter DB1 mit Druckluft auf, die unter relativ hohem Druck steht. Der Druckbehälter DB1 ist andererseits über ein Ventil V an die Saugleitung SL der Pumpe P angeschlossen. Beim Aufsetzen oder kurz nach dem Aufsetzen eines von der Saugpipette SP gehaltenen Bauelementes BE auf eine in der Zeichnung nicht dargestellte Leiterplatte, wird das Ventil V geöffnt und damit eine schnelle Abgabe des Inhalts des Druckbehälters DB1 in den Unterdruckbereich zwischen Pumpe P und Saugpipette SP bewirkt. Dadurch ergibt sich in der Saugpipette SP ein sehr schneller Druckanstieg beim Abgeben des jeweils gehaltenen Bauelementes BE. Der Querschnitt des Drosselorgans DO1 ist so bemessen, daß in der Saugpipette SP bei laufender Pumpe P ein konstanter Druck gehalten wird.

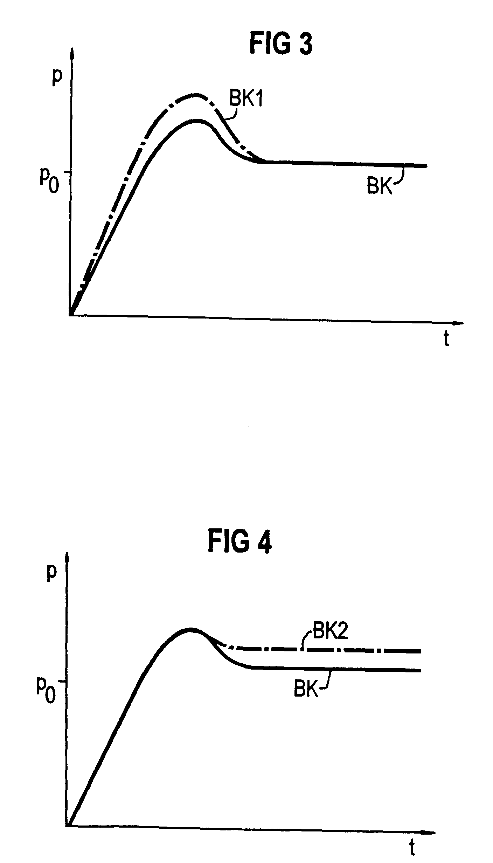

Figur 2 zeigt eine Variante, bei welcher der Druckbehälter DB2 mit einstellbarem Volumen über ein Drosselorgan DO2 mit einstellbarem Querschnitt mit Druckluft aus der Druckluftquelle DQ gefüllt wird. Die übrigen Teile entsprechen der Darstellung gemäß Figur 1. Durch die Einstellbarkeit des Querschnittes des Drosselorgans DO2 und/oder des Volumens des Druckbehälters DB2 kann bei der Druckumsteuerung von Unterdruck auf Blasluft die Blasluft-Kennlinie in ihrem Verlauf an die jeweiligen Gegebenheiten angepaßt werden. Zu den entsprechenden Möglichkeiten einer Beeinflussung wird auf die Figuren 3 und 4 verwiesen.

Figur 3 zeigt als Blasdruck-Kennlinie BK die Abhängigkeit des in der Saugpipette SP (vergleiche Figuren 1 und 2) herrschenden Blasdruckes p von der Zeit t. Der Atmosphärendruck ist mit p₀ bezeichnet. Es ist ersichtlich, daß bei der mit Hilfe des Ventils V (vergleiche Figuren 1 und 2) vorgenommenen Umsteuerung von Unterdruck auf Blasluft, der Blasdruck p sehr schnell ansteigt und nach Erreichen eines Maximum auf einen oberhalb des Atmosphärendrucks p₀ liegenden konstanten Blasdruck absinkt. Die strichpunktiert dargestellte Blasdruck-Kennlinie BK1 zeigt den Verlauf bei einem größeren Volumen des Druckbehälter DB2 (vergleiche Figur 2). Es ist ersichtlich, daß dieses größere Volumen zu einem schnelleren Druckanstieg bei der Druckumsteuerung und zu einem höheren Maximum des Blasdrucks führt.

Figur 4 zeigt den Einfluß des Queschnitts des einstellbaren Drosselorgans DO2 (vergleiche Figur 2) auf die Blasdruck-Kennlinie, deren Normalverlauf auch hier wieder mit BK bezeichnet ist. Die strichpunktiert dargestellte Blasdruck-Kennlinie BK2 zeigt den Verlauf bei einem größeren Querschnitt des einstellbaren Drosselorgans DO2 (vergleiche Figur 2). Es ist ersichtlich, daß die geringere Drosselwirkung des Drosselorgans DO2 zu einem höheren Wert des konstanten Blasdrucks p führt, der sich nach dem Erreichen des maximalen Wertes in der Saugpipette SP (vergleiche Figuren 1 und 2) einstellt.

Durch die Wahl der Einstellung des Querschnitts des Drosselorgans DO2 und des Volumens des Druckbehälters DB2 (vergleiche Figur 2), können bei der Umstellung von Unterdruck auf Blasluft die Geschwindigkeit des Druckanstiegs in der Saugpipette SP, die maximale Höhe des Blasdrucks und der konstante Wert des Blasdruckes nach dem Überschreiten des Maximums optimal an die jeweiligen Gegebenheiten angepaßt werden.

## Patentansprüche

1. Vorrichtung zur Handhabung von Teilen, insbesondere zum Bestücken von Leiterplatten mit Bauelementen (BE), mit
- mindestens einer Saugpipette (SP), zum Aufnehmen, Halten und Abgeben der Teile,
- einer saugseitig an die Saugpipette (SP) angeschlossenen Pumpe (P) zur Erzeugung eines Unterdrucks beim Aufnehmen und Halten der Teile, und mit
- einem Druckbehälter (DB1;DB2), aus welchem über ein Ventil (V) beim Abgeben der Teile Druckluft in den Unterdruckbereich zwischen Pumpe (P) und Saugpipette (SP) eingeleitet wird.

2. Vorrichtung nach Anspruch 1,
**dadurch gekennzeichnet,**
daß die Pumpe (P) durch eine, an eine Druckluftquelle (DQ) angeschlossene Strahlpumpe gebildet ist, und daß der Druckbehälter (DB1;DB2) über ein Drosselorgan (DO1;DO2) von der Druckluftquelle (DQ) gefüllt wird.

3. Vorrichtung nach Anspruch 2,
**dadurch gekennzeichnet,**
daß der Querschnitt des Drosselorgans (DO2) einstellbar ist.

4. Vorrichtung nach einem der Ansprüche 1 bis 3,
**dadurch gekennzeichnet,**
daß das Volumen des Druckbehälters (DB2) einstellbar ist.

## Claims

1. Device for handling parts, in particular for fitting components (BE) on printed circuit boards, having
- at least one suction tube (SP) for receiving, retaining and releasing the parts,
- a pump (P) which is connected on the suction side to the suction tube (SP) and is intended for generating a negative pressure when receiving and retaining the parts, and having
- a pressure vessel (DB1; DB2) from which, via a valve (V), compressed air is introduced into the negative-pressure region between the pump (P) and suction tube (SP) when releasing the parts.

2. Device according to Claim 1, characterized in that the pump (P) is formed by a jet pump which is connected to a compressed-air source (DQ), and in that the pressure vessel (DB1; DB2) is filled by the compressed-air source (DQ) via a throttle element (DO1; DO2).

3. Device according to Claim 2, characterized in that it is possible to set the cross section of the throttle element (DO2).

4. Device according to one of Claims 1 to 3, characterized in that it is possible to set the volume of the pressure vessel (DB2) .

## Revendications

1. Dispositif de manipulation de pièces, notamment pour équiper de composants (BE) des cartes de circuits imprimés, comprenant
- au moins un tube d'aspiration (SP), pour saisir, maintenir et relâcher les pièces,
- une pompe (P), raccordée du côté d'aspiration au tube d'aspiration (SP) afin de produire une dépression lors de la saisie et du maintien des pièces, et comprenant
- un réservoir de pression (DB1 ; DB2) à partir duquel, lorsque les pièces sont relâchées, de l'air comprimé est, par l'intermédiaire d'une vanne (V), introduit dans la zone de dépression entre la pompe (P) et le tube d'aspiration (SP).

2. Dispositif selon la revendication 1, **caractérisé** en ce que la pompe (P) est une pompe à jet raccordée à une source d'air comprimé (DQ), et en ce que le réservoir de pression (DB1 ; DB2) est rempli par la source d'air comprimé (DQ) par l'intermédiaire d'un organe d'étranglement (DO1 ; DO2).

3. Dispositif selon la revendication 2, **caractérisé** en ce que la section transversale de l'organe d'étranglement (DO2) est réglable

4. Dispositif selon l'une des revendications 1 à 3, **caractérisé** en ce que le volume du réservoir de pression (DB2) est réglable.
